Europäisches Patentamt

**European Patent Office**

**Office européen des brevets**

(11) Publication number: **0 265 631 B1**

# EUROPEAN PATENT SPECIFICATION

(45) Date of publication of patent specification: **26.08.92**   (51) Int. Cl.⁵: **H01L 23/48**, H01L 23/52

(21) Application number: **87112731.2**

(22) Date of filing: **01.09.87**

(54) **Use of tapered head pin design to improve the stress distribution in the braze joint.**

(30) Priority: **28.10.86 US 924081**

(43) Date of publication of application:
**04.05.88 Bulletin  88/18**

(45) Publication of the grant of the patent:
**26.08.92 Bulletin  92/35**

(84) Designated Contracting States:
**DE FR GB IT**

(56) References cited:
**US-A- 4 418 857**

**IBM TECHNICAL DISCLOSURE BULLETIN, vol. 27, no. 5, October 1984, pages 3057,3058, New York, US; C.H. PERRY: "Pin repair using ultrasonic aluminum bonding"**

**PATENT ABSTRACTS OF JAPAN, vol. 10, no. 309 (E-447)[2365], 21st October 1986; & JP-A-61 123 160 (FUJITSU LTD) 11-06-1986**

**PATENT ABSTRACTS OF JAPAN, vol. 9, no. 115 (E-315)[1838], 18th May 1985; & JP-A-60 5546 (SHINKOU DENKI KOGYO K.K.) 12-01-1985**

(73) Proprietor: **International Business Machines Corporation
Old Orchard Road
Armonk, N.Y. 10504(US)**

(72) Inventor: **Agarwala, Birendra Nath
69 Brandy Lane
Wappingers Falls N.Y. 12590(US)**
Inventor: **Palmateer, Paul Harry
40 Montford Rd.
Wappingers Falls N.Y. 12590(US)**
Inventor: **Shih, Da Yuan
16 Vervalen Drive
Poughkeepsie N.Y. 12603(US)**

(74) Representative: **Colas, Alain
Compagnie IBM France Département de Propriété Intellectuelle
F-06610 La Gaude(FR)**

## Description

The invention relates to the joining of connector pins to a metallic pad formed on a multilayer ceramic substrate. More particularly, a tapered head pin design is taught which relieves the stresses created at the pin:pad interface.

In the field of semiconductor packaging, the use of multilayer ceramic technology is widespread. In a typical package, the semiconductor chips are mounted on one surface of the multilayer ceramic substrate and the substrate is provided with I/O pins or connectors on the reverse side for mounting or interconnection with the next level of packaging. Throughout the substrate is located a network of metallurgy for interconnection from the pins to the integrated circuit devices mounted on the top surface. The I/O pins are ordinarily bonded, by a braze or solder process, to a bonding pad which is the termination pad of the internal metallurgy system. The termination pads are formed either in a conventional method, such as the screening of metal pastes through a mask prior to the sintering thereof, or by metallization by electron beam evaporation, sputtering or other methods after sintering. The I/O pins are then bonded to the termination pads, usually by means of a Au-Sn braze. The bonding material must be sufficiently strong to withstand the environmental conditions met in operation; and, the braze alloy should also be one that is not significantly affected by the thermal and tensile stresses associated with the processing steps undertaken for completion of the package, such as the device mounting procedures. Since the multilayer ceramic substrates are designed to carry a large number of devices, there is ordinarily a need for several rework steps to allow for device defects and engineering changes. The bonds between the I/O pins and the termination pads must therefore withstand many temperature cycles in the course of the processing and reworking stages. Beyond the fabrication considerations, tensile stresses are created in the vicinity of the I/O pads during usage and have been found to be dependent upon the size, thickness and geometry of the termination pads, the material properties of the pads, the pin joint morphology, and the distribution and material properties of the braze alloy. With this knowledge, various approaches to stress relief in the I/O pin region have been explored. With regard to the thermal stresses, a materialsrelated approach has been attempted in order to match the thermal expansion coefficients of the associated materials. For example, Kovar (a trademark of Westinghouse Electric Corporation) is commonly used as a pin material as it has a thermal expansion coefficient which is compatible with that of an alumina substrate. The braze and pad materials can be altered in order to provide intermediary TCE's between the substrate and the pin materials in order to reduce the thermal stresses, as taught in U.S.-A-4.418.857 to Ainslie, et al and 4.518.112 to Miller et al. In addition to the braze alloy material modification, the Ainslie and Miller patents, both assigned to the present assignee, teach that the braze or fillet volume and the fillet morphology can affect the strength of the braze joint. The Miller patent seeks to reduce the volume of the fillet material to avoid the "tendency to creep upwardly reducing the strength of the joint..."(Column 1, lines 63-68). The Ainslie patent teaches a process which "...prevents the pin climb of metal up the shank of a pin..."(Column 5, lines 35-36). Similarly, the fillet amount and fillet morphology is discussed in IEEE article by Sahara, et al entitled "Improvement of Metallization for Alumina Substrates", Electronic Components Conference Proceedings, May 1982, pages 32-35, wherein it is taught that the recommended volume of bonding material is the minimum volume necessary to achieve the bond. As further illustrated in that article, at page 34 in Figure 8, the stress profile for the reduced fillet volume sample (at [1]) is far more favorable than the stress profile for the higher fillet volume sample (at [2]). Still another reference, U.S-A-4.634.041, entitled "Process for Bonding Current Carrying Elements To a Substrate in an Electronic System, and Structures Thereof", teaches the use of a pin head having a diameter which is significantly smaller than the diameter of the bonding pad in order to decrease the volume of the braze alloy and therefore decrease the likelihood of migration of the braze alloy. All indications from these sources are that the ideal pin joint has a low volume of the braze deposited between the pin head and the bonding pad and not extending in any direction beyond the periphery of the pin head itself. During the rework procedures, however, the braze materials will migrate, the braze volume will be redistributed and the braze/fillet morphology will shift thereby increasing the stresses.

JP-A-61 123 160 shows pin connectors used in semiconductor integrated circuit packaging assemblies, which pins have a tapered portion between the shank and the flat bonding surface of the pin. An electrical welding method is employed in bonding the pins to metallic pads on a substrate, so as to avoid thermal stress to the whole package.

It is an objective of the invention to provide a pin connector which provides minimum stress to the bonding pad and the underlying ceramic when brazed to the bonding pad.

It is another objective of the invention to minimize the braze thickness gradient thereby more evenly distributing the stresses across the entire ceramic contact surface.

It is still another objective of the invention to provide a connector geometry which will prevent the redistribution and migration of the bonding material during further processing steps.

It is a further objective of the invention to provide a connection system which will increase the peeling and bending resistance of the pin joint.

These and other objectives will be met by the present invention wherein a connector is taught which has a shank portion, a flat head for connection, and a tapered portion extending from the flat head to the shank.

Figure 1 illustrates a connector having a flat head of the type found in the art today.

Figure 2 depicts the prior art connector brazed to a bonding pad on a ceramic substrate.

Figures 3A-D illustrate connectors designed in accordance with the teachings of the present invention.

Figure 4 illustrates the braze stresses across the pin joint using the prior art flatedged pin and the taperedhead pin of the present invention.

Figures 5A and 5B are crosssectional views of the joints formed between the ceramic substrates and connectors from the prior art and in accordance with the present invention.

Figures 6A and 6B are crosssectional views of the joints between the ceramic substrates and the connectors from the prior art and in accordance with the present invention after several reflow steps.

Figures 7A and 7B illustrate the braze morphology and the amount of pad material reacted with the braze during brazing and reflow processes using the prior art pin geometry.

Figures 8A and 8B illustrate the braze morphology and the amount of pad material reacted with the braze during brazing and reflow processes using the present inventive pin geometry.

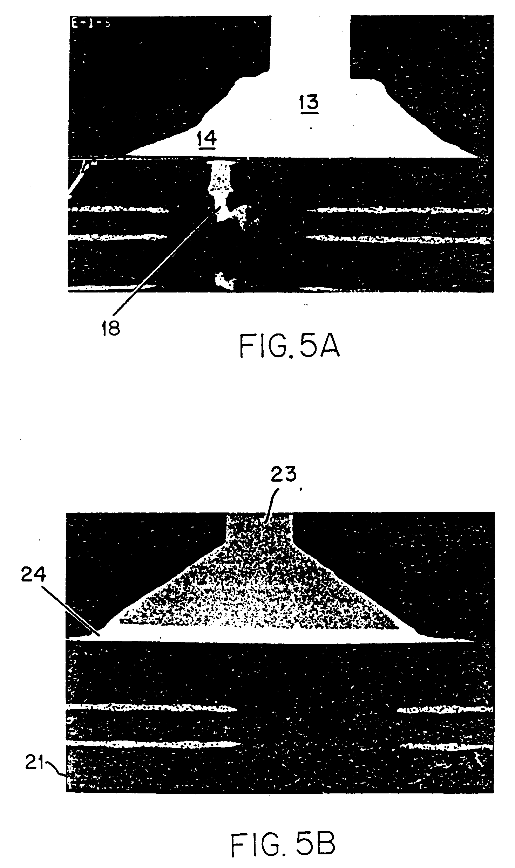

The use of high bond strength materials to attach connectors is common in the electronic components industry. Braze alloys and the metallurgy associated with the bonding pads can generate stresses in the substrate which exceed the fracture strength of the ceramic leading to failures in the ceramic itself. Analysis of the braze process and the resulting joint have led to modifications designed to reduce the stress. The stress on the ceramic substrate is the result of a combination of forces. Stress is created at the interface of the multilayer ceramic and the bonding pad due to the thermal expansion mismatch. The brittle substrate is subjected to considerable stress in the vicinity of the pad edges due to this TCE mismatch. Further stress is created in the brazed joint itself due to the thermal expansion mismatch between the pad and the braze. The bonding pad is generally comprised of several layers of different metallurgy selected to provide both adhesion to the substrate and a wettable surface for the braze or solder bonding material. Therefore, stresses are generated within the pad itself due to thermal mismatches. Although efforts are made to match the TCE's of the adjoining materials, additional factors contribute to the braze:pad stress which cannot be as readily addressed. Those additional stressproducing mechanisms include the tendency of the braze to react with the pad and form intermetallic compounds which increase the stress within the pad; and, the reactivity of the braze with other materials encountered during the remaining MLC processing steps, rendering the braze more brittle and, again, creating more stress. The tensile stress imparted by the braze joint to the pad is directed through the pad to the underlying MLC substrate. Therefore, the ceramic substrate must withstand the sum of the stresses. The total tensile stress is further concentrated on the ceramic areas located beneath the pad at the periphery of the pin head due to a tendency of the braze to wet and collect at the pin head and pad edges. This effect produces a thickness gradient whereby the thick fillet located at the pin head periphery produces a stress concentration on the glass ceramic which can result in cracks in the substrate, as illustrated in Figure 5A at 18, and eventual nonrepairable fracture of the ceramic.

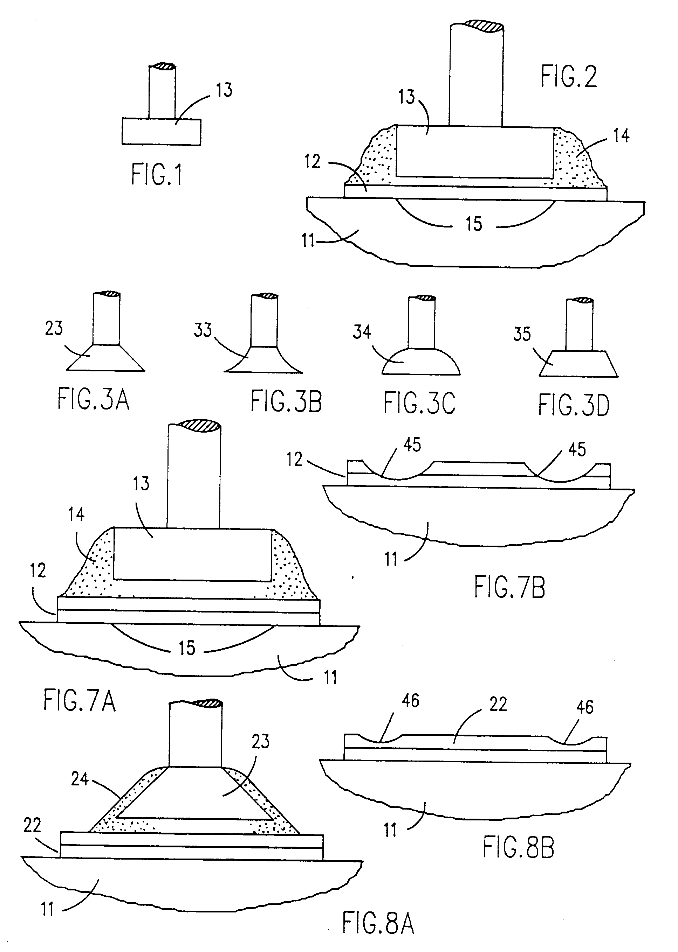

The present invention, as illustrated in Figure 3, is a pin connector which is tapered from the shank to the flat surface at which connection is made to the bonding surface. The unique design minimizes the stress imparted to the ceramic by reducing the volume of the braze, which would ordinarily collect at the pin head periphery. The thickness gradient is minimized allowing for a "distribution" of the stresses along the entire contact surface of the ceramic. A further advantage of the tapered head is that the fillet morphology will remain unchanged after numerous reflows. In addition, a reduced overall volume of the fillet or braze can be achieved with the tapered head which will significantly reduce the reaction and migration rate of the braze with the pad metallurgy. Mechanically, the advantage of tapering the head results in a tapering away from the load force on the pins,pad and ceramic; said force being applied by the bending or peeling stresses associated with handling and insertion of the finished package. A tapering away from the load force can reduce the bending moment at the pin head periphery and pad edges and, as a consequence, increase the peel and bending resistance of the braze joint.

As illustrated in Figures 3A-D, the angle of taper is not critical nor is the exact geometry of the head. Straight edges, or beveled edges, tapered from the shank out to the bonding surface of the pin are illustrated along with convex and concave tapers. What is necessary is some degree of tapering away from the vertical in order to distribute the stresses. As noted above, the total stress on the pad/substrate is the result of a combination of forces. The tensile stress $\alpha$ t is a result of both a vertical component $\alpha$ v and a horizontal component $\alpha$ h. Theoretically, when fabricating a symmetrical pin whereby the shank diameter is one third of the diameter of the bonding surface, the combined stress will be the least if a 45° angle of taper is used, thereby "splitting" the stress components, so that $\alpha$ v = $\alpha$ h with neither stress component having a high peak stress thereby, minimizing the total stress, $\alpha$ t. The relative dimensions of the pin shank diameter and the pin head diameter are not 1 imited by the geometry of the tapered head, whereas the dimensions are limited when a standard pin head is fabricated using the coldheading process. The coldheading process is well known in the art as a method for fabricating connectors such as pins and nails. The geometry of the flatedge headed pin which is known in the art dictates that the ratio of the diameter of the molded, or coldheaded, head to the diameter of the shank be approximately 2,4:1, given the volume of pin material necessary to comprise the bulk flatedged head. However, the taperheaded design necessarily uses a lower volume of pin material. Therefore, with the tapered head pin, a higher pin head diameter:shank diameter ratio can be achieved; for example, a 3,7:1 ratio has been achieved in the coldheading fabrication of a beveledhead pin. From a coldheading fabrication standpoint, the tapered head is not only desirable in use, but it is also desirable for economic and throughput considerations.

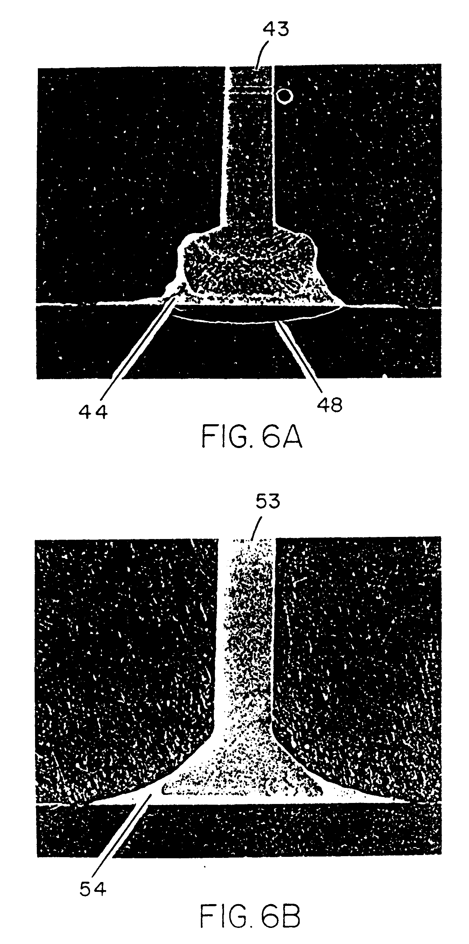

Figures 2 and 8 illustrate the advantages gained by the use of the proposed tapered head pin in stress relief. Figure 2 depicts a standard flat head pin, 13, mounted by fillet, 14, to the bonding pad, 12, on a substrate, 11. The fillet, as illustrated therein, collects at the pin head periphery, 15, and consequently increases the stress on the ceramic directly beneath the high volume of fillet. The illustration labeled Figure 5A reveals a crack, 18, in the underlying ceramic at the point at which the stress is increased by the concentration of fillet. Not only is the tensile stress increased by the volume of fillet; but, also, the pad material is reacted more completely by the greater amount of braze material. As illustrated in Figure 7B at 45, the bonding pad material in the vicinity of the pin head periphery, and therefore in the vicinity of the highest concentration of braze volume, has been reacted and depleted to the extent that delamination from the substrate may occur. Reaction with the wettable surface of the pad can be desirable; however, the higher volume of braze tends to react with the underlying pad material also. The more braze that is reacted with the underlying bonding pad material in that localized area, the more brittle the braze alloy may become thereby creating greater stress on the substrate. Figure 6A also illustrates the standard flat head pin, 43, and associated fillet morphology, 44, after several reflows. The fillet, or braze has redistributed and reacted with the pad creating associated stresses which have generated severe cracks, 48, in the underlying ceramic. The geometry of the tapered head pin, however, illustrated in Figure 8A at 23 having a beveled edge, minimizes the fillet volume at the pin head periphery. A uniform distribution of braze, 24, is achieved, as is the consequent uniform stress distribution. As can be noted in Figure 5B, and again after several reflows in Figure 6B, no cracks are generated in the underlying ceramic when the tapered head pin is used. Furthermore, there is little change in the fillet morphology, Figure 6B at 54, after reflow processes have been carried out. Additionally, as illustrated in Figure 8B, less of the pad material is reacted by the braze since a lower volume of braze is needed when using the taperheaded pin. In the instance of the taperedheaded pin, all of the braze material is reacted with a small amount of the wettable surface of the bonding pad material to create a braze alloy having a higher concentration of the wettable material, for example Au (from the gold plating on both the pins and the pad). As such, the resulting Au enriched braze alloy has a higher melting temperature. Subsequent reflow steps will not melt the Au enriched braze as readily as the unreacted braze of the past and therefore the braze will not redistribute to create greater stresses.

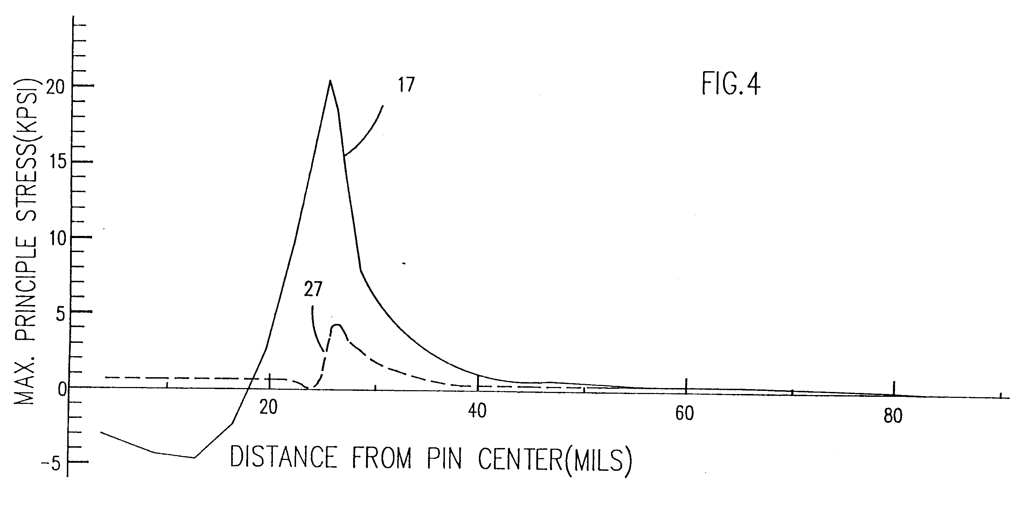

The combination of advantageous features of the tapered head design result in vastly reduced stress across the bonding surface as illustrated in Figure 4. The graphic illustration indicates that at least a 50% decrease in stress results from the use of the new pin geometry. The sample pins used were fabricated from the same materials (in the tests as illustrated, Invar was used as a pin material for both samples) to eliminate any variables. However, in subsequent testing wherein both flatedged and beveledhead pins were fabricated of several different materials, having different thermal coefficients of expansion, it was discovered that the beveledhead pin geometry reduced stress to the same degree regardless of the materials used. Specifically, an Invar beveled pin and a Kovar beveled pin were tested on a substrate. It was found that although the TCE's of the respective samples differ greatly, there was little difference in the stresses created by the Kovar and the Invar beveled pins on the substrate. Such results indicate that the tensile stresses which are relieved by the beveling geometry are far greater than the thermal stresses created by TCE mismatch.

The invention has been described with reference to several working embodiments utilizing materials known to be used in the art today. The invention is not intended to be limited to the materials or the specific applications discussed.

**Claims**

1. A pin connector to be brazed to a metallic pad located on a ceramic substrate for electrically connecting said pad on the substrate to another electrical entity, the connector comprising:
   a flat bonding surface having a first diameter;
   a shank for interconnection having a second diameter which is less than said first diameter;
   a tapered portion extending from the shank to the bonding surface, at an acute angle to said bonding surface.

2. The pin connector of Claim 1, wherein the tapered portion is beveled at an angle of 45°.

3. The pin connector of Claim 1 or 2, wherein the tapered portion is concave.

4. The pin connector of Claim 1 or 2, wherein the tapered portion is convex.

5. The pin connector of anyone of the preceding Claims, wherein the ratio of the diameter of the bonding surface to the diameter of the shank is greater than 2,4:1.

6. A semiconductor integrated circuit packaging assembly utilizing a plurality of pin connectors according to anyone of the preceding claims.

**Patentansprüche**

1. Stiftverbinder, der auf eine auf einem keramischen Substrat gelegene, metallische Anschlußfläche hart aufgelötet werden soll, um die Anschlußfläche auf dem Substrat elektrisch mit einer anderen elektrischen Einheit zu verbinden, wobei der Verbinder aufweist:
   eine ebene Bindeoberfläche mit einem ersten Durchmesser;
   einen Schaft zum Verbinden mit einem zweiten Durchmesser, der kleiner als der erste Durchmesser ist;
   einen sich verjüngenden Abschnitt, der unter einem spitzen Winkel zu der Bindeoberfläche von dem Schaft zu der Bindeoberfläche verläuft.

2. Stiftverbinder nach Anspruch 1, bei welchem der sich verjüngenden Abschnitt unter einem Winkel von 45° abgeschrägt ist.

3. Stiftverbinder nach Anspruch 1 oder 2, bei welchem der sich verjüngende Abschnitt konkav ist.

4. Stiftverbinder nach Anspruch 1 oder 2, bei welchem der sich verjüngende Abschnitt konvex ist.

5. Stiftverbinder nach einem der vorgehenden Ansprüche, bei welchem das Verhältnis des Durchmessers der Bindeoberfläche zu dem Durchmesser des Schafts größer als 2,4 : 1 ist.

6. Integrierte Halbleiterschaltung-Gehäuseeinheit, welche eine Mehrzahl von Stiftverbindern nach irgendeinem der vorgehenden Ansprüche verwendet.

**Revendications**

1. Connecteur à broche à braser à un plot métallique situé sur un substrat en céramique, pour connecter électriquement ledit plot sur le substrat à une autre entité électrique, le connecteur comprenant :
   une surface de jonction plane ayant un premier diamètre ;
   une tige d'interconnexion, ayant un deuxième diamètre qui est plus petit que ledit premier diamètre ;
   une partie conique s'étendant de la tige à la surface de jonction et définissant un angle aigu avec ladite surface de jonction.

2. Connecteur à broche suivant la revendication 1, dans lequel la partie conique est biseautée suivant un angle de 45°.

3. Connecteur à broche suivant la revendication 1 ou 2, dans lequel la partie conique présente une surface concave.

4. Connecteur à broche suivant la revendication 1 ou 2, dans lequel la partie conique présente une surface convexe.

5. Connecteur à broche suivant l'une quelconque des revendications précédentes, dans lequel le rapport du diamètre de la surface de jonction au diamètre de la tige est supérieur à 2,4:1.

6. Assemblage de groupage de circuit intégré semiconducteur utilisant une pluralité de connecteurs à broche suivant l'une quelconque

des revendications précédentes.

FIG.1

FIG.2

FIG.3A

FIG.3B

FIG.3C

FIG.3D

FIG.7A

FIG.7B

FIG.8A

FIG.8B

FIG.4

17

27

MAX. PRINCIPLE STRESS(KPSI)

-20 -15 -10 -5 0 -5

DISTANCE FROM PIN CENTER(MILS)

20 40 60 80

FIG. 5A

FIG. 5B

FIG. 6A

FIG. 6B